# EUROPEAN PATENT SPECIFICATION

(11) **EP 2 380 203 B1**
(45) Date of publication and mention of the grant of the patent: **20.02.2013**
(21) Application number: 09801964.9
(22) Date of filing: 16.12.2009
(51) Int. Cl.: H01L 31/0216, H01L 31/0224

(54) **SOLAR CELL**
SOLARZELLE
PILE SOLAIRE

(30) Priority: 19.12.2008 DE 102008055028
(43) Date of publication of application: 26.10.2011
(73) Proprietor: Hanwha Q-CELLS GmbH, 06766 Bitterfeld-Wolfen (DE)
(72) Inventor: ENGELHART, Peter, 04157 Leizig (DE); WANKA, Sven, 04105 Leipzig (DE); DINGEMANS, Gijs, 5021 VX Tilburg (NL); KESSELS, Wilhelmus Mathijs Marie, 5045 ZZ Tilburg (NL)
(74) Representative: Bakhtyari, Arash
(86) International application number: PCT/EP2009/067349
(87) International publication number: WO 2010/070015

(56) References cited:
- DE-A1-102005 040 871
- US-A- 4 253 881
- US-A- 5 125 984
- D. KÖNIG ET AL: "P inversion layer Si solar cells as test for the I-S structure: results and prospects" 3RD WORLD CONFERENCE ON PHOTOVOLTAIC ENERGY CONVERSION, 18 May 2003 (2003-05-18), pages 232-2355, XP002572842 Osaka, japan
- MOHAMED M HILALI ET AL: "Two-Dimensional Modeling of EWT Multicrystalline Silicon Solar Cells and Comparison with the IBC Solar Cell" PHOTOVOLTAIC ENERGY CONVERSION, CONFERENCE RECORD OF THE 2006 IEEE 4TH WORLD CONFERENCE ON, IEEE, PI, 1 May 2006 (2006-05-01), pages 1299-1303, XP031007553 ISBN: 978-1-4244-0016-4
- HEZEL ET AL: "Silicon nitride for the improvement of silicon inversion layer solar cells" SOLID STATE ELECTRONICS, ELSEVIER SCIENCE PUBLISHERS, BARKING, GB, vol. 24, no. 9, 1 September 1981 (1981-09-01), pages 863-868, XP025753175 ISSN: 0038-1101 [retrieved on 1981-09-01]

## Description

The invention relates to a solar cell with an inversion layer or accumulation layer.

In order to separate free charge carriers in a semiconductor, which charge carriers have been generated by means of incident light, semiconductor solar cells conventionally comprise semiconductor regions that are made from different materials and/or are doped with different doping materials. Between the two semiconductor regions, which as a rule are designated as base and emitter, a heterojunction and/or a pn-junction then form/forms, in which the free charge carriers are separated thus forming a tappable voltage.

Instead of, or in addition to, doping, the base and emitter can also be produced in that charge carriers are induced in a surface region of a doped semiconductor in order to, in that region, produce an inversion layer or accumulation layer. In a manner that is similar to that in a field effect transistor, due to band bending, in the doped semiconductor thus either additional majority charge carriers are drawn to the surface region in order to form an accumulation layer, or minority charge carriers are drawn in while majority charge carriers are pushed away from the surface region in order to achieve a charge carrier inversion and in this way form an inversion layer. As a result of the formation of the inversion layer or accumulation layer at the same time passivation of the semiconductor surface is achieved, because, as a result of pushing away a charge carrier type, charge carrier recombination at surface defects is reduced.

Silicon nitride (SiNₓ), which is used in so-called MIS (metal insulator semiconductor) solar cells, is known as a possible material for producing an inversion layer or accumulation layer. In this arrangement an inducing layer made of SiNₓ is applied to a semiconductor layer. Due to the positive surface charge density of the SiNₓ-layer, in a surface region of the semiconductor layer, depending on the doping of the semiconductor layer, an inversion layer or an accumulation layer is produced. The inversion layer or accumulation layer can at the same time be used for surface passivation and as an emitter layer, wherein the semiconductor layer acts as a base layer.

Inducing layers made of conventional materials such as SiNₓ are associated with a disadvantage in that with them only a small charge carrier inversion or charge carrier accumulation can be achieved. This results in an inversion layer or accumulation layer with only slight lateral conductivity. Furthermore, they do not form adequately passivating layers so that processing of the semiconductor surface needs to meet stringent requirements, in particular in the case on non-crystalline surfaces.

US 4,253,881 refers to metal insulator semiconductor (MIS) solar cells and inversion layer solar cells. In one embodiment, the known solar cell comprises two insulating layers on the front side of its semiconductor substrate. The insulating layers comprise a silicon oxide layer grown directly onto the semiconductor substrate and a silicon nitride deposited on top of the Si02 layer. This second insulating layer is made such that it has a high surface charge density of 5-7 x 10¹² cm⁻².

"p Inversion Layer Si Solar Cells...", D. König et al., is a conference paper referring to solar cells having inversion layers. This solar cell structure comprises an n-type silicon layer covered by an AlF₃ layer. The p-type inversion layer is induced underneath the AlF₃ layer inside the silicon layer due to the negative surface charge of the AlF₃ layer.

DE 10 2005 040 871 A1 and "Two-Dimensional Modeling of...", M. M. Hilali et al., are concerned with the production and computational modeling of emitter wrap through (EWT) solar cells.

In the publication "Silicon Nitride for the Improvement...", R. Hezel, the authors discuss the effects of various deposition parameters on the surface charge density of silicon nitride layers. In one exemplary case, the dependence of the surface charge density of a silicon nitride layer on the deposition temperature was examined, whereby a maximum charge density of 7x10¹²cm-² could be reported. Regarding the experimental setup, the silicon nitride layer is arranged on a native silicon dioxide layer covering the silicon layer.

US 5,125,984 discloses a solar cell having a semiconductor layer, wherein an inversion layer is induced. According to one embodiment, a solar cell structure having a p-type semiconductor layer covered by a silicon nitride layer and an antireflective layer is described. The silicon nitride layer is deposited such that it contains positive charges, which induce a layer of negative charges in the underlying semiconductor layer, thus forming an induced inversion layer.

It is the object of the invention to obtain a solar cell with an inversion layer or accumulation layer that comprises increased lateral conductivity. Moreover, surface passivation of the solar cell is to be improved.

According to the invention this object is met by a solar cell with the characteristics of claim 1. Advantageous embodiments of the invention are stated in the subordinate claims.

The invention is based on the recognition that a high surface charge density of at least 10¹² cm⁻², preferably of at least 10¹³ cm⁻², can not only induce inversion layers and accumulation layers with enhanced lateral conductivity, but also results in improved surface passivation. Whether or not an inversion layer or an accumulation layer is induced depends not only on the type and intensity of any doping of the semiconductor layer, but also on the sign and on the intensity of the charges induced by means of the inducing layer. The inducing layer can comprise either a positive or a negative surface charge density.

The inversion layer preferably is essentially completely made of the material with the mentioned surface charge density. Furthermore, it is advantageous, but not mandatory, for the inducing layer to be arranged directly on the semiconductor layer. Further intermediate layers can also be arranged between the inducing layer and the semiconductor layer, which intermediate layers are used for improved bonding, and/or influence mechanical and/or electronic characteristics of the solar cell.

That the inversion layer is essentially made of a certain material means in particular that the inversion layer may comprise traces of other materials due to imperfections in the fabrication process, in the raw materials or the like.

A possible method for producing such a solar cell comprises the provision of a semiconductor layer, for example as a semiconductor wafer or as a thin layer, which has been vapour-deposited onto a substrate. The inducing layer is then applied to this semiconductor layer. However, the reverse sequence is also imaginable, in which the inducing layer is applied to the substrate, which inducing layer may comprise a collecting layer or a contact layer. Thereafter the semiconductor layer is applied to this inducing layer.

In this arrangement the semiconductor layer can be completely or partly doped, for example in a region in which the inversion layer or the accumulation layer is to be induced. Due to the surface charge density of the inducing layer, band bending occurs in the semiconductor layer, which band bending results in separation of the free charge carriers that arise in the semiconductor.

In order to collect the charge carriers that have been divided in this manner, as part of the manufacturing method contacting of the solar cell must take place. In this arrangement, with a corresponding material selection, the inducing layer can serve as a tunnel layer, or tunnel regions can form in the inducing layer. The induced inversion layer or accumulation layer can moreover act as a back-surface field (BSF). Furthermore, an induced accumulation layer provides an advantage in that the lateral conductivity of the majorities in the semiconductor layer that acts as an absorber is increased. With semiconductor wafers becoming thinner and thinner, this additional lateral conductivity assumes great importance in order to minimise ohmic losses.

According to an advantageous embodiment, the buffer layer is essentially made of a material with a negative surface charge density. Aluminium fluoride (AlF₃) with a negative charge density of between approximately 10¹² and approximately 10¹³ cm⁻² is one example of a material with negative surface charge density. Negative surface charge density provides an advantage in that the material is particularly suitable for inducing an accumulation layer in a p-type semiconductor layer, which, for example, in the field of silicon-based photovoltaics is by far the most frequently-used doping.

An expedient improvement provides for the inducing layer to comprise aluminium oxide (Al₂O₃). An aluminium oxide layer is particularly suited to good surface passivation. Furthermore, it comprises a high negative surface charge density, by means of which a p-type inversion layer or accumulation layer with high lateral conductivity can be manufactured. Furthermore, the aluminium oxide layer can in a simple manner be applied very thinly but nonetheless evenly.

A preferred embodiment provides for a diffusion layer to be formed underneath the inducing layer in the semiconductor layer, wherein the inversion layer or accumulation layer which is induced due to the inducing layer is partly or fully formed in the diffusion layer. For example, if the diffusion layer is of the n-type, as a result of the inducing layer, depending on the selection of materials, an n⁺-type accumulation layer or a p-type inversion layer can be induced. The diffusion layer can, for example, be produced by means of boron doping.

A preferred embodiment provides for the inducing layer to be formed without pinholes. In other words the inducing layer is formed so evenly and/or free of faults that no through-openings (pinholes) form in it. In this case the inducing layer is electrically adequately insulated and is thus, in particular, well suited to the creation of tunnel contacts.

Preferably, the inducing layer is formed by means of atomic layer deposition (ALD). By means of ALD it is possible to form particularly even and complete layers in particular from aluminium oxide. Furthermore, the layer thickness can be set very precisely, in ideal cases to an accuracy of one atomic layer.

An advantageous improvement provides for the inducing layer to comprise a thickness ranging between 0.1 and 10 nanometres, preferably between 0.1 and 5 nanometres. Preferably, the inducing layer (even when very thin, in the magnitude of a few atomic layers) is electrically insulating so that in it tunnel regions form through which free charge carriers tunnel from the inversion layer or accumulation layer into a conductive layer or the like that is arranged above the inducing layer.

As an alternative, other layer thicknesses can also be advantageous. For example, for optical adaptation large thickness layers on the front and/or on the back of the solar cell are advantageous. In order to obtain such a combination layer which acts as a tunnel layer, while at the same time obtaining optical advantages such as anti-reflection adaptation or improved back-surface reflection in conjunction with back-surface metallization, an overall layer thickness greater than approximately 50 nm can be advantageous. For example, with the use of aluminium dioxide for the front anti-reflection adaptation, a layer thickness of greater than, or equal to, approximately 50 nm is expedient. In contrast to this, with the use of aluminium dioxide for improved back-surface reflection, a layer thickness of greater than, or equal to, 100 nm is sensible.

An expedient embodiment provides for the inducing layer to extend essentially over an entire surface of the semiconductor layer. This can, in particular, be met also if a conductive layer applied to the inducing layer is structured, for example, to form finger-shaped conductive layer regions, between which exposed intermediate regions have been formed. The feature presently described then requires the inducing layer to be arranged both underneath the conductive layer in the conductive layer regions, and in the intermediate regions that are not covered by the conductive layer, on the semiconductor layer. In other words the same surface charge density is used to form the inversion layer or accumulation layer, irrespective as to whether or not the corresponding region is covered by the structured conductive layer.

According to a preferred embodiment, the semiconductor layer comprises crystalline or amorphous silicon. The crystalline silicon can, for example, be present in the form of a wafer. However, it can also be present in the form of microcrystalline silicon. The amorphous silicon can have been manufactured in a vapour-deposition process on a substrate or superstrate, for example made of glass, that if need be is coated with a transparent conductive material.

Expediently it is provided for a conductive layer to be arranged on a side of the inducing layer, which side points away from the semiconductor layer. The conductive layer is used to collect the free charge carriers that have been generated in the semiconductor and that have been separated due to band bending. Said conductive layer can have been applied over the entire area or it can be structured, for example in order to form finger contacts. The conductive layer can comprise a metal layer and/or a layer comprising a transparent conductive material, for example a transparent conductive oxide such as indium tin oxide (ITO) or zinc oxide. Said conductive layer can also comprise several layers, for example a continuous transparent conductive layer and a structured metal layer arranged above it. If below the inducing layer an additional doping layer is provided, then doping for this is preferably concentrated underneath the metal layer, for example to regions underneath the finger contacts, in order to form improved electrical contact to the conductive layer.

In particular the use of Al₂O₃ to form an inducing layer underneath a metal contact provides an advantage in that due to said metal contact both a tunnel contact and an inversion layer are formed underneath the metal contact. In the case of the solar cells mentioned in the introduction, which solar cells comprise inversion layers of SiNₓ, several layers of different materials are used in order to achieve these two effects: a layer comprising SiNₓ to produce the inversion layer, and SiO₂ underneath the metal contact to form the tunnel contact. Al₂O₃ thus provides an advantage in that it requires a simpler structure for the above, with only one material system.

A preferred improvement provides for a crystalline or amorphous further semiconductor layer to be formed on a side of the inducing layer, which side points away from the semiconductor layer. When the semiconductor layer is formed from a crystalline semiconductor material, for example from crystalline silicon (c-Si), then the further semiconductor layer can be made from an amorphous semiconductor material such as amorphous silicon (a-Si) in order to form a heterojunction or heterocontact to a conductive layer arranged above it.

Conventionally, such heterojunctions are formed from a layer sequence comprising c-Si and a-Si and an intrinsic amorphous silicon layer arranged between them. In this arrangement the intrinsic amorphous silicon layer is used for surface passivation. In the present embodiment this passivating action is carried out by the inducing layer, which hereinafter can also be referred to as a "buffer layer". The buffer layer furthermore forms a tunnel layer in the heterojunction, through which tunnel layer charge carriers tunnel, which charge carriers are collected in the a-Si layer that has been vapour-deposited thereon.

The use of the buffer layer instead of the intrinsic amorphous silicon layer provides an advantage in that the layer thickness of the buffer layer can be set much more precisely, in particular if it is a layer vapour-deposited by means of ALD, for example a layer comprising aluminium oxide. If the contact is a p⁺-heterocontact in which thus the semiconductor layer is p-doped and the further semiconductor layer is p⁺-doped, a p⁺-type inversion layer, for example induced by an aluminium oxide layer, acts as an additional electronic drain for the holes.

In an expedient embodiment the solar cell is designed as a back-contacted solar cell. Preferably, the solar cell is designed as an emitter-wrap-through solar cell (EWT solar cell). The EWT solar cell comprises pinholes through which the emitter regions extend from a light-incidence face or front of the solar cell to a back surface of the solar cell, which back surface faces away from the light-incidence face. The pinholes can, for example, comprise a circular cross section.

Preferably, in this arrangement the inducing layer extends partially or entirely over the hole walls of the pinholes of the EWT solar cell. This includes the case where the inducing layer extends exclusively over the hole walls, in other words over the semiconductor layer in the pinholes, rather than over a solar cell surface. In this case the term "semiconductor layer" refers to a cylindrical layer around the pinhole.

Electrical conduction within a pinhole or through a pinhole is through the inversion layer or accumulation layer, in contrast to charge carrier conduction through a doping layer or diffusion layer formed along the hole wall. In this context precise control of vapour-deposition of the inducing layer and also of any further layers in the pinhole is particularly important. Isotropic vapour-deposition of the inducing layer along the hole wall of a pinhole is particularly advantageous. This takes place, for example, with the use of ALD.

The inducing layer produced by means of suitable methods or processes, for example ALD, can comprise very good electrical characteristics even with a very thin layer thickness in particular in the pinholes of the EWT solar cell. For this reason the EWT solar cell can comprise pinholes of a smaller hole diameter than is conventionally the case. This improves surface utilisation of the solar cell.

An advantageous embodiment provides for the inducing layer to extend over the semiconductor layer in the pinholes only on one solar cell surface and/or on both solar cell surfaces. This results in great design variety in the use of such an inducing layer in solar cells.

Below, the invention is explained with reference to the figures on the basis of exemplary embodiments. The following are shown in diagrammatic cross-sectional drawings:
- Fig. 1: a solar cell comprising an inducing layer arranged underneath a front-surface electrode;
- Fig. 2: a solar cell according to a further embodiment with an inducing layer arranged underneath a back-surface electrode;
- Fig. 3: a further solar cell with an inducing layer arranged underneath a heterojunction layer;
- Fig. 4: an embodiment of an EWT solar cell; and
- Fig. 5: a further embodiment of an EWT solar cell.

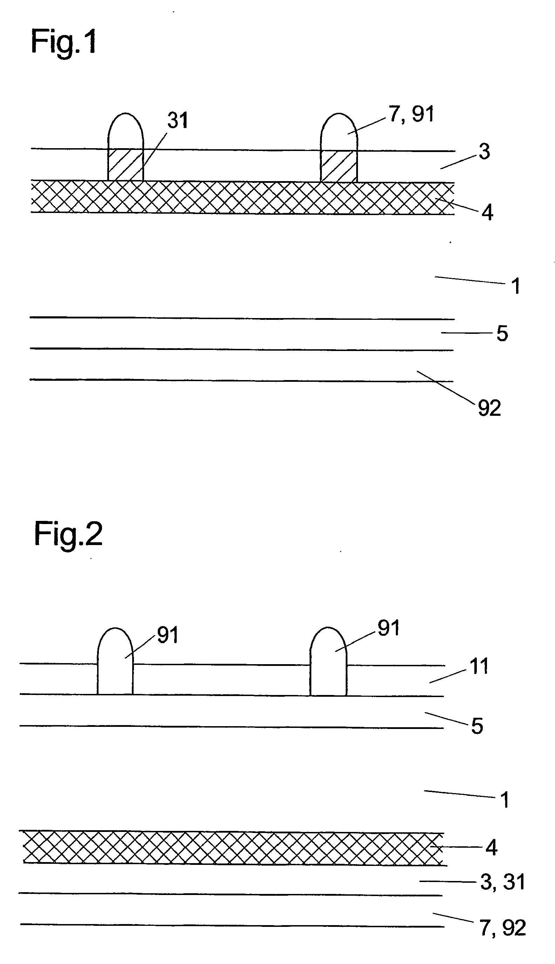

Fig. 1 shows a solar cell comprising a semiconductor layer 1 and an inducing layer 3 vapour-deposited thereon. Immediately underneath the inducing layer 3, an inversion layer or accumulation layer 4 is induced in the semiconductor layer 1. Depending on the sign of the surface charge of the inversion layer 3, the inversion layer or accumulation layer 4 is an n-type or a p-type. The depth and the layer thickness of the inversion layer or accumulation layer 4 depends on the materials of the semiconductor layer 1 and of the inducing layer 3 as well as on the surface charge density of the inducing layer 3.

The inducing layer 3, which is preferably electrically insulating, furthermore in some regions forms tunnel contacts 31 between the semiconductor layer 1 and a conductive layer 7 applied to the inducing layer 3. The conductive layer 7 is structured to form finger-shaped contacts (finger electrodes), thus forming a front-surface electrode 91 of the solar cell. It preferably comprises a metal or a metal alloy.

If the semiconductor layer 1 is an n-type semiconductor wafer that is covered by an inducing layer 3 with negative surface charge, for example an aluminium oxide, a p-type inversion layer 4 is induced in the semiconductor layer 1. In this case the charge-separating pn-junction between the n-type semiconductor layer 1 and the p-type inversion layer 4 is formed.

As an alternative to this, the semiconductor layer 1 can originally be p-doped so that an inducing layer 3 with a negative surface charge induces a p⁺-type accumulation layer 4 in the semiconductor layer 1. This accumulation layer 4 can then serve to control the electrical characteristics of the tunnel contacts 31.

On a face of the semiconductor layer 1, which face points away from the inducing layer 3, a doping layer 5 is provided which is formed, for example, by means of diffusion of a doping material in the semiconductor layer 1. On the doping layer 5 a back-surface electrode 92 is arranged. Depending on the conductive type of the doping layer 5 when compared to the semiconductor layer 1, in-between either a pn-junction is created or an ohmic connection between the semiconductor layer 1 and the back-surface electrode 92 is formed.

Fig. 2 shows a further embodiment of a solar cell in which the inducing layer 3 has been applied to the back-surface of the semiconductor layer 1, in other words on a face of the solar cell, which face points away from the light-incidence face. In contrast to the embodiment according to Fig. 1, the front-surface electrode 91 has thus been applied to a doping layer 5, while a conductive layer 7, which essentially extends over the entire area, is arranged on the inducing layer 3, thus forming a back-surface electrode 92. Since the conductive layer 7 covers the entire area, the entire inducing layer 3 serves as a tunnel region 31 or tunnel layer between the conductive layer 7 and the semiconductor layer 1 of the inversion layer or accumulation layer 4 induced by the inducing layer 3.

In addition, on the doping layer 5 of the solar cell from Fig. 2 an anti-reflection layer 11 is arranged, which encompasses the finger contacts of the front-surface electrode 91. As a result of the selection of the material and of the layer thickness of the anti-reflection layer 11, reflection of the light that impinges the solar cell is considerably reduced, for example in a visible and/or infrared region. With the selection of a suitable material and a suitable layer thickness, in the embodiment of the solar cell according to Fig. 1 the inducing layer 3 can be designed as an anti-reflection layer.

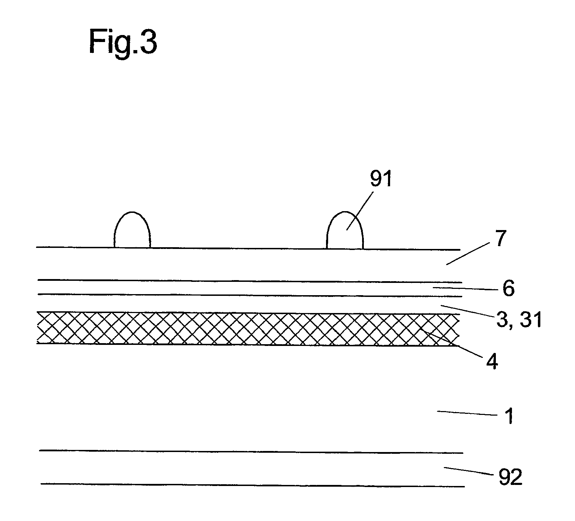

Fig. 3 shows a solar cell with a heterojunction. It comprises a semiconductor layer 1 with an inducing layer 3 arranged thereon, underneath which, as already explained, an inversion layer or accumulation layer 4 forms. Above the inversion layer 3 a heterojunction layer 6 from an amorphous semiconductor material has been applied, for example by means of a physical vapour-deposition (PVD) process or a chemical vapour-deposition (CVD) process. Between the heterojunction layer 6 and the semiconductor layer 1 the heterojunction forms, wherein the inducing layer 3 at the same time acts both as a buffer layer 3 and as a tunnel contact 31, through which free charge carriers move from the semiconductor layer 1 into the heterojunction layer 6.

In the present embodiment of Fig. 3 the inducing layer 3 thus serves both to induce the inversion layer or accumulation layer 4 and to form a tunnel contact 31. Furthermore, the inducing layer 3 can be used for surface passivation. The heterojunction layer 6 is covered by a conductive layer 7, which comprises, for example, a transparent conductive material such as zinc oxide or indium tin oxide. In order to tap the charge carriers that have moved from the heterojunction layer 6 to the conductive layer 7, on the conductive layer 7, finger-shaped front-surface electrodes 91 have been applied. In the present case the conductive layer 7 can have been designed to at the same time be an anti-reflection layer.

Finally, on a face of the semiconductor layer 1, which face points away from the heterojunction layer 6, a back-surface electrode 92 that covers the entire area has been applied directly. The back-surface electrode 92 serves to build up a back-surface field (BSF); wherein said back-surface electrode 92 can, for example, comprise aluminium which, for example, has been applied in paste form. However, it is also possible for the solar cell on the back face, too, to comprise one of the contacts explained above in the context of Figs 1 to 3, for example a heterojunction.

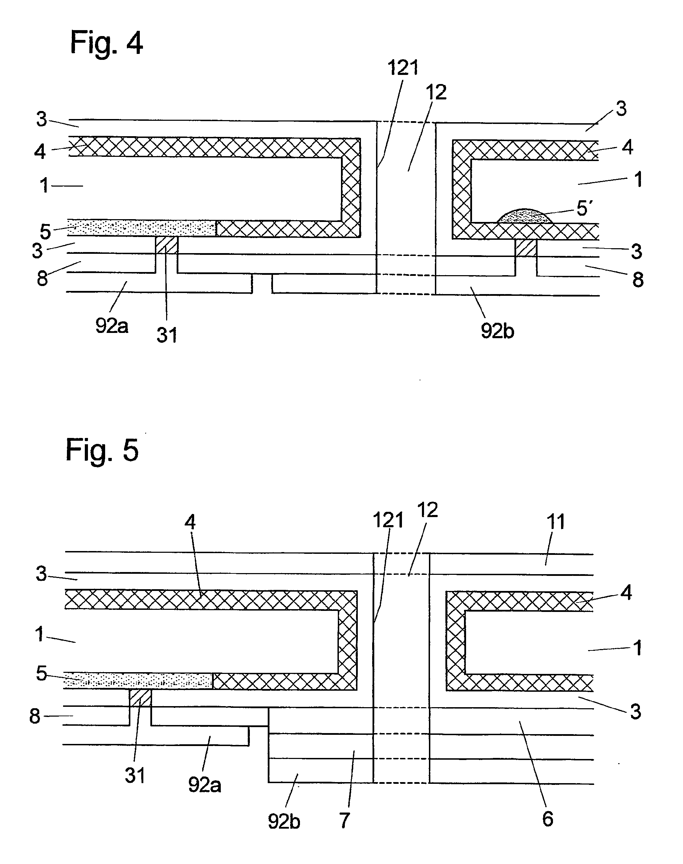

Fig. 4 shows an emitter-wrap-through solar cell (EWT solar cell) with two back-surface electrodes 92a, 92b. The EWT solar cell comprises a semiconductor layer 1, for example comprising a semiconductor wafer, with pinholes 12 extending through the former, wherein Fig. 4 only shows one pinhole 12. The semiconductor layer 1 is covered on both faces with an inducing layer 3 that also extends over the hole wall 121 of the pinhole 12. Directly underneath the inducing layer 3, in the semiconductor layer 1 an inversion layer or accumulation layer 4 is induced. Furthermore, in one region the semiconductor layer 1 underneath the inducing layer 3 comprises a doping layer 5 which can, for example, have been produced by means of diffusion prior to the application of the inducing layer 3.

The inversion layer or accumulation layer 4 can either form the charge-separating junction to the semiconductor layer 1, or it serves to influence the tunnel contact 31, formed by the inducing layer 3, to one of the back-surface electrodes 92a, 92b if it is an accumulation layer 4. In a similar manner the doping layer 5 can be designed to form a charge-separating junction between the semiconductor layer 1 and the doping layer 5, for example in that the semiconductor layer 1 is n-doped and the doping layer 5 is of the p-type. As an alternative the doping layer 5 can serve to influence the tunnel contact 31 between the doping layer 5 and one of the back-surface electrodes 92a, 92b, for example if the semiconductor layer 1 is n-doped and the doping layer 5 is n⁺-doped.

In the present case, for example, the doping layer 5 comprises the same conductive type, namely p-type or n-type conductivity, as the semiconductor layer 1, which generally is regarded as the base. The doping layer 5 is thus connected to the back-surface base electrode 92a by way of the tunnel contact 31 in the inducing layer 3. In contrast to this the inversion layer or accumulation layer 4 induced by the inducing layer 3 is connected to the back-surface emitter electrode 92b by way of a tunnel contact 31 in the inducing layer 3. Furthermore, in the embodiment shown, underneath the tunnel contact 31 to the back-surface emitter electrode 92b, in the semiconductor layer 1 in addition a further doping layer 5' is formed. The further doping layer 5' can, for example, be an n⁺-type or p⁺-type region generated by means of diffusion of a doping material, for example boron.

Underneath the back-surface base electrode 92a and the back-surface emitter electrode 92b an insulation layer 8 is provided, which comprises openings at the locations at which tunnel contacts 31 to the semiconductor layer 1 are provided.

The dashed lines in Fig. 4 indicate that the pinhole 12 also extends through the further layers 3, 8, 92b. This also applies in Fig. 5 to the further layers 6, 7, 11, 92b.

Fig. 5 shows a further EWT solar cell. It differs from the embodiment shown in Fig. 4 in that the back-surface emitter electrode 92b is contacted to the solar cell by way of a heterojunction that comprises a heterojunction layer 6 arranged on the inducing layer 3. Between the back-surface emitter electrode 92b and the heterojunction layer 6, furthermore, a conductive layer 7 is arranged. The conductive layer 7 can, for example, comprise a transparent conductive material and can be used to improve back reflection of electromagnetic radiation impinging on the back-surface emitter electrode 92b, back in the direction of the semiconductor layer 1.

Furthermore, on its light-incidence face the EWT solar cell of Fig. 5 comprises an anti-reflection layer 11. Such an anti-reflection layer 11 can also be provided on the EWT solar cell according to the exemplary embodiment of Fig. 4. As an alternative in both exemplary embodiments the inducing layer 3, at least on the light-incidence face or the front surface of the solar cell, can be designed as an anti-reflection layer, so that there is no longer any need to provide an additional anti-reflection layer 11.

The embodiments described above essentially comprise plane layers of semiconductors that extend any desired distance along two Cartesian coordinates. While they are not shown, layers that are formed in some other way are also possible, for example dish-shaped or cup-shaped curved layers. Furthermore, these layers can have been formed in the manner of an island on the solar cell.

### List of reference characters:

- 1: Semiconductor layer
- 3: Inducing layer (buffer layer)
- 3a: Front-surface inducing layer (buffer layer)
- 3b: Back-surface inducing layer (buffer layer)
- 31: Tunnel contact (tunnel region)
- 4: Inversion layer, accumulation layer
- 5: Doping layer
- 5': Further doping layer
- 6: Heterojunction layer
- 7: Conductive layer
- 8: Insulation layer
- 91: Front-surface electrode
- 92: Back-surface electrode
- 92a: Back-surface base electrode
- 92b: Back-surface emitter electrode
- 11: Anti-reflection layer
- 12: Pinhole
- 121: Hole wall

## Claims

1. A solar cell comprising a semiconductor layer (1) with a first doping, an inducing layer (3) arranged on the semiconductor layer (1) and an inversion layer (4) or accumulation layer (4) which due to the inducing layer (3) is induced underneath the inducing layer (3) in the semiconductor layer (1), whereby the inducing layer (3) is essentially completely made of a material with a surface charge density of at least 10¹² cm⁻², preferably of at least 5x10¹² cm⁻², more preferably of at least 10¹³ cm⁻², **characterized by** that the inducing layer (3) is arranged directly on the semiconductor layer (1).

2. The solar cell according to claim 1 or 2, **characterised in that** the buffer layer (3) is essentially made of a material with a negative surface charge density.

3. The solar cell according to claim 1, **characterised in that** the inducing layer (3) comprises aluminium oxide.

4. The solar cell according to one of claims 1 or 2, **characterised in that** a diffusion layer (5) is formed underneath the inducing layer (3) in the semiconductor layer (1), wherein the inversion layer (4) or accumulation layer (4) which is induced due to the inducing layer (3) is partly or fully formed in the diffusion layer (5).

5. The solar cell according to any one of the preceding claims, **characterised in that** the inducing layer (3) is formed without pinholes.

6. The solar cell according to any one of the preceding claims, **characterised in that** the inducing layer (3) is formed by means of atomic layer deposition.

7. The solar cell according to any one of the preceding claims, **characterised in that** the inducing layer (3) comprises a thickness ranging between 0.1 and 10 nm, preferably between 0.1 and 5 nm.

8. The solar cell according to any one of the preceding claims, **characterised in that** the inducing layer (3) extends essentially over an entire surface of the semiconductor layer (1).

9. The solar cell according to any one of the preceding claims, **characterised in that** the semiconductor layer (1) comprises crystalline or amorphous silicon.

10. The solar cell according to any one of the preceding claims, **characterised in that** a conductive layer (7) is arranged on a side of the inducing layer (3), which side points away from the semiconductor layer (1).

11. The solar cell according to any one of claims 1 to 8, **characterised in that** a crystalline or amorphous further semiconductor layer (1) is formed on a side of the inducing layer (3), which side points away from the semiconductor layer (1).

12. The solar cell according to any one of the preceding claims, **characterised in that** the solar cell is designed as a back-contacted solar cell.

13. The solar cell according to claim 11, **characterised in that** the solar cell is designed as an emitter-wrap-through solar cell.

14. The solar cell according to claim 12, **characterised in that** the inducing layer (3) extends entirely or partially over the hole walls of the pinholes (12) of the emitter-wrap-through solar cell.

15. The solar cell according to any one of the preceding claims, **characterised in that** the inducing layer (3) extends over the semiconductor layer (1) in the pinholes (12) only on one solar cell surface and/or on both solar cell surfaces.

## Patentansprüche

1. Solarzelle mit einer Halbleiterschicht (1) mit einer ersten Dotierung, einer auf der Halbleiterschicht (1) angeordneten Induzierschicht (3) und einer aufgrund der Induzierschicht (3) unterhalb der Induzierschicht (3) in der Halbleiterschicht (1) induzierten Inversionsschicht (4) oder Akkumulationsschicht (4), wobei die Induzierschicht (3) im Wesentlichen vollständig aus einem Material mit einer Flächenladungsdichte von mindestens 10¹² cm⁻², vorzugsweise von mindestens 5x10¹² cm⁻², bevorzugt von mindestens 10¹³ cm⁻² gebildet ist, **dadurch gekennzeichnet, dass** die Induzierschicht (3) unmittelbar auf der Halbleiterschicht angeordnet ist.

2. Solarzelle nach Anspruch 1 oder 2, **dadurch gekennzeichnet, dass** die Pufferschicht (3) im Wesentlichen aus einem Material mit einer negativen Flächenladungsdichte gebildet ist.

3. Solarzelle nach Anspruch 1, **dadurch gekennzeichnet, dass** die Induzierschicht (3) Aluminiumoxid umfasst.

4. Solarzelle nach einem der Ansprüche 1 oder 2, **dadurch gekennzeichnet, dass** unterhalb der Induzierschicht (3) in der Halbleiterschicht (1) eine Diffusionsschicht (5) gebildet ist, wobei die aufgrund der Induzierschicht (3) induzierte Inversionsschicht (4) oder Akkumulationsschicht (4) teilweise oder vollständig in der Diffusionsschicht (5) gebildet ist.

5. Solarzelle nach einem der vorangehenden Ansprüche, **dadurch gekennzeichnet, dass** die Induzierschicht (3) pinholefrei gebildet ist.

6. Solarzelle nach einem der vorangehenden Ansprüche, **dadurch gekennzeichnet, dass** die Induzierschicht (3) mittels Atomlagenabscheidung gebildet ist.

7. Solarzelle nach einem der vorangehenden Ansprüche, **dadurch gekennzeichnet, dass** die Induzierschicht (3) eine Dicke in einem Bereich zwischen 0,1 und 10 nm, vorzugsweise zwischen 0,1 und 5 nm aufweist.

8. Solarzelle nach einem der vorangehenden Ansprüche, **dadurch gekennzeichnet, dass** sich die Induzierschicht (3) über im Wesentlichen eine gesamte Oberfläche der Halbleiterschicht (1) erstreckt.

9. Solarzelle nach einem der vorangehenden Ansprüche, **dadurch gekennzeichnet, dass** die Halbleiterschicht (1) kristallines oder amorphes Silizium umfasst.

10. Solarzelle nach einem der vorangehenden Ansprüche, **dadurch gekennzeichnet, dass** auf einer der Halbleiterschicht (1) abgewandten Seite der Induzierschicht (3) eine Leitungsschicht (7) angeordnet ist.

11. Solarzelle nach einem der Ansprüche 1 bis 8, **dadurch gekennzeichnet, dass** auf einer der Halbleiterschicht (1) abgewandten Seite der Induzierschicht (3) eine kristalline oder amorphe weitere Halbleiterschicht (1) gebildet ist.

12. Solarzelle nach einem der vorangehenden Ansprüche, **dadurch gekennzeichnet, dass** die Solarzelle als rückseitenkontaktierte Solarzelle ausgebildet ist.

13. Solarzelle nach Anspruch 11, **dadurch gekennzeichnet, dass** die Solarzelle als eine Emitter-Wrap-Through-Solarzelle ausgebildet ist.

14. Solarzelle nach Anspruch 12, **dadurch gekennzeichnet, dass** sich die Induzierschicht (3) vollständig oder teilweise über Lochwände von Durchgangslöchern (12) der Emitter-Wrap-Through-Solarzelle erstreckt.

15. Solarzelle nach einem der vorangehenden Ansprüche, **dadurch gekennzeichnet, dass** sich die Induzierschicht (3) über die Halbleiterschicht (1) in den Durchgangslöchern (12) auf nur einer Solarzellenoberfläche und / oder auf beiden Solarzellenoberflächen erstreckt.

## Revendications

1. Une cellule solaire comprenant une couche semi-conductrice (1) avec un premier dopage, une couche d'induction (3) laquelle est arrangée sur la couche semi-conductrice (1) et une couche d'inversion (4) ou une couche d'accumulation (4) laquelle est induite par la couche d'induction (3) sous la couche d'induction (3) dans la couche semi-conductrice (1), la couche d'induction (3) étant constituée essentiellement complètement par un matériau avec une densité de charge de surface d'au moins 10¹² cm⁻², de préférence d'au moins 5x10¹² cm⁻² ou de manière plus préférée d'au moins 10¹³ cm⁻², **caractérisée en ce que** la couche d'induction (3) est arrangée directement sur la couche semi-conductrice (1).

2. La cellule solaire selon la revendication 1 ou 2, **caractérisée en ce que** la couche tampon (3) est constituée essentiellement par un matériau avec une densité de charge de surface négative.

3. La cellule solaire selon la revendication 1, **caractérisée en ce que** la couche d'induction (3) comprend d'oxyde d'aluminium.

4. La cellule solaire selon une des revendications 1 ou 2, **caractérisée en ce qu'**une couche de diffusion (5) est formée sous la couche d'induction (3) dans la couche semi-conductrice (1), la couche d'inversion (4) ou la couche d'accumulation (4) laquelle est induite par la couche d'induction (3) étant formée partiellement ou complètement dans la couche de diffusion (5).

5. La cellule solaire selon une des revendications précédentes, **caractérisée en ce que** la couche d'induction (3) est formée sans trous.

6. La cellule solaire selon une des revendications précédentes, **caractérisée en ce que** la couche d'induction (3) est formée au moyen de dépôt par couches atomiques.

7. La cellule solaire selon une des revendications précédentes, **caractérisée en ce que** la couche d'induction (3) comprend une épaisseur entre 0,1 et 10 nm, de préférence entre 0,1 et 5 nm.

8. La cellule solaire selon une des revendications précédentes, **caractérisée en ce que** la couche d'induction (3) s'étend essentiellement sur une surface entière de la couche semi-conductrice (1).

9. La cellule solaire selon une des revendications précédentes, **caractérisée en ce que** la couche semi-conductrice (1) comprend du silicium cristallin ou amorphe.

10. La cellule solaire selon une des revendications précédentes, **caractérisée en ce qu'**une couche conductrice (7) est arrangée à un côté de la couche d'induction (3), le côté pointant à l'opposé de la couche semi-conductrice (1).

11. La cellule solaire selon une des revendications 1 à 8, **caractérisée en ce qu'**une autre couche semi-conductrice cristalline ou amorphe (1) est formée à un côté de la couche d'induction (3), le côté pointant à l'opposé de la couche semi-conductrice (1).

12. La cellule solaire selon une des revendications précédentes, **caractérisée en ce que** la cellule solaire est conçue comme une cellule solaire à contact arrière.

13. La cellule solaire selon la revendication 11, **caractérisée en ce que** la cellule solaire est conçue comme une cellule solaire Emitter Wrap Through.

14. La cellule solaire selon la revendication 12, **caractérisée en ce que** la couche d'induction (3) s'étend complètement ou partiellement sur les parois d'orifice des trous (12) de la cellule solaire Emitter Wrap Through.

15. La cellule solaire selon une des revendications précédentes, **caractérisée en ce que** la couche d'induction (3) s'étend sur la couche semi-conductrice (1) dans les trous (12) seulement à une surface de la cellule solaire et/ou aux deux surfaces de la cellule solaire.
